# EUROPEAN PATENT APPLICATION

(11) **EP 3 173 690 A1**
(43) Date of publication of application: **31.05.2017**
(21) Application number: 15197109.0
(22) Date of filing: 30.11.2015
(51) Int. Cl.: F21V 8/00, G02B 6/124, G02B 6/34

(54) **METHOD AND TEMPLATE FOR PRODUCING A LIGHT OUT-COUPLING PORTION ON A SURFACE OF A LIGHT GUIDE**

(71) Applicant: Embedded Nano Europe AB, 113 42 Stockholm (SE)
(72) Inventor: MONTELIUS, Lars, 4710-230 Braga (PT)
(74) Representative: Lindgren, Sven Erik Andreas

(57) **Abstract**

A method for producing a light out-coupling portion on a surface of a light guide (304) is provided. The method (200) comprising the acts of: applying (202) a template (100, 308, 400) comprising a pattern (102, 310) representing a structure of the light out-coupling portion (302) at the surface of the light guide (304), heating (204) the template (100, 308, 400) to a given temperature whereby a portion (316) of the surface of the light guide (304) is locally melted and solidified such that the pattern (102, 310) is transferred to the surface of the light guide (304) forming the light out-coupling portion (302). A container (306) comprising a light out-coupling portion (302) produced by the method (200) and template (100, 308, 400) for producing a light out-coupling portion (302) on a surface of a light guide (304) are further provided.

## Description

### Field of invention

The present invention relates to a method for producing a light out-coupling portion on a surface of a light guide, a template for producing a light out-coupling portion on a surface of a light guide, and a light guide comprising a light out-coupling portion.

### Technical background

In lighting devices there is often a need for utilizing patterned surfaces for improving the efficiency at which light is coupled out of a light guide. The light guide may for example be a light concentrator, an optical fibre or, as will be exemplified in this application, a wall of a container. It is, however, challenging to produce such patterns, especially after the light guide has been manufactured.

### Summary of invention

An object of the present invention is to provide means for forming a light out-coupling portion on a surface of a light guide.

According to a first aspect this is achieved by providing a method comprising the acts of: applying a template comprising a pattern representing a structure of the light out-coupling portion at the surface of the light guide, heating the template to a given temperature, whereby a portion of the surface of the light guide is locally melted and solidified such that the pattern is transferred to the surface of the light guide forming the light out-coupling portion.

A method for efficient transfer of the pattern from the template to the surface of a light guide is thereby achieved. The wording *"template"* should be construed as a physical object whose geometrical shape may be used to shape or reshape a portion of another object. Hence, the wording *"transfer"* of the pattern should be understood as that the shape of the template is used to change the shape of the surface of the light guide. The method thereby enables the replication of arbitrary surface patterns from the template into the surface of the light guide. The template may be understood as a stamp or a mould arranged to transfer a pattern to a portion of the surface of the light guide such that a light out-coupling portion is formed. A light out-coupling portion comprising a surface structure may efficiently be formed on the surface of the light guide.

A more pronounced light out-coupling portion, i.e. a high fidelity of the transferred pattern may further be realized by the method.

The *"given temperature"* should be construed as a temperature which facilitated local melting of the material forming the surface of the light guide.

The pattern may comprise ordered and/or random features.

The pattern of the template may form an inverse pattern on the container wall surface.

The method further allows for reshaping of the surface of the light guide after the light guide has been manufactured. A flexible and versatile method for patterning a surface is provided. An improved freedom to choose the location at which the pattern is formed on the surface of the light guide is further achieved by the method.

The wording *"at the surface of a light guide"* should be understood as the template being brought in contact with or in the vicinity of the surface of the light guide such that the pattern may be transferred to the surface of the light guide. Hence, heat generated by the heating of the template may be transferred to a portion of the surface of the light guide such that it is melted locally.

The wording *"light out-coupling surface"* should be understood as a surface arranged to refract, diffract, reflect and/or scatter light, or any combination thereof out from the surface of the light guide. Hence, the template may comprise features, for example nanometer scale patterns, which are transferred to the surface of the light guide.

The act of applying may further comprise applying the template on an inner surface of the light guide. Hence, a pattern may be formed inside the surface of the light guide.

The act of heating the template may comprise heating the template to a given temperature in the range of 500°C - 900 °C. This temperature range may facilitate efficient local melting of the material forming the surface of the light guide.

The act of heating the template may be provided for a time period in the range of 1 - 10 microseconds. The time period of the heating allows for the features of the pattern to be efficiently transferred into the surface of the light guide by the method. A high throughput method for patterning a surface of a light guide may thereby be provided.

The method may further comprise the act of pressing the template to the surface of the light guide. The material of the surface of the light guide is redistributed by the forces resulting from the pressing of the template into the surface of the light guide. In other words, the pattern is stamped into the surface of the light guide. Heat is, moreover, more efficiently transferred from the template to the surface of the light guide by the increased contact area achieved when pressing the template to the surface of the light guide. The template may be pressed into the surface of the light guide.

The pressing of the template into the surface of the light guide may thereby efficiently create an inverse structure of the template pattern resulting in that the surface of the light guide has a varying thickness.

The method may further comprise the act of cooling the template. The cooling of the template offers faster solidification of the locally melted portion of the light guide such that the pattern may be efficiently transferred to the surface of the light guide. In other words, the cooling mitigates re-flow of material of the light guide after the template is removed from the surface of the light guide.

The act of pressing may be performed while the act of heating and/or the act of cooling is performed. The features of the pattern may thereby be stamped into the surface of the light guide such that a light out-coupling portion with a higher fidelity is provided efficiently. A faster and more accurate transfer of the pattern of the template to the surface of the light guide may thereby be realized by the method.

The act of pressing and the act of cooling may be performed in a time period in the range of 1 - 10 milliseconds. A method for high throughput of the patterning of a surface of a light guide may thereby be provided. The time period reduces the amount of material in the surface of the light guide that is heated which improves the resolution of the pattern that is formed in the surface of the light guide. A light out-coupling portion having higher fidelity may therefore be provided by the method.

The method may further comprise the act of metalizing at least a sub-portion of the light out-coupling portion.

The light out-coupling portion may form a plasmonic structure.

The plasmonic structure may provide a localized surface plasmon resonance, LSPR.

The light out-coupling portion may comprise a surface-enhanced Raman scattering, SERS, structure.

The light guide may comprise a glass material.

The light guide may be a container such as a bottle.

The light out-coupling portion may comprise a lens structure, a grating structure, and/or a corrugated surface.

According to a second aspect a template for producing a light out-coupling portion on a surface of a light guide is provided. The template comprising: a substrate comprising a pattern representing a structure of a light out-coupling portion to be formed on the surface of the light guide, and a heating element arranged to heat the substrate to a given temperature whereby a portion of the container wall surface is locally melted and solidified such that the pattern is transferred to the container wall surface forming the light out-coupling portion.

The template may further comprise a cooler arranged to cool the surface of the light guide such that it is solidified and the pattern may efficiently be transferred to a surface of the light guide forming the light out-coupling portion. The features of the pattern may thereby be efficiently transferred and faster solidified, i.e. "frozen", into the surface of the light guide such that a light out-coupling portion with a higher fidelity may be provided. A more accurate transfer of the pattern of the template to the surface of the light guide may thereby be realized by the template.

The template may have a width in the range of 5 mm - 40 mm, and a thickness of in the range of 0.5 mm - 3 mm. The dimension of the template provides patterning over a local area of the light guide. In other words, the location of the light out-coupling portion on the light guide may easily be adjusted for each light guide offering a way to uniquely pattern a light guide. The dimensions of the template further allow the template to be heated or cooled efficiently. The dimensions of the template simplify insertion of the template into a light guide when patterning an inner surface of the light guide.

The template may have a length in the range of 5 mm - 100 mm.

The template may comprise a substrate having a metalized surface structure, the metalized surface structure comprising the pattern.

The pattern may comprise nanometer scale features.

The above mentioned features of the method, when applicable, apply to the second aspects as well. In order to avoid undue repetition, reference is made to the above.

According to a third aspect a light guide comprising a light out-coupling portion produced according to the above is provided.

The above mentioned features of the method and template, when applicable, apply to the third aspects as well. In order to avoid undue repetition, reference is made to the above.

A further scope of applicability of the present invention will become apparent from the detailed description given below. However, it should be understood that the detailed description and specific examples, while indicating preferred embodiments of the invention, are given by way of illustration only, since various changes and modifications within the scope of the invention will become apparent to those skilled in the art from this detailed description.

Hence, it is to be understood that this invention is not limited to the particular component parts of the device described or steps of the methods described as such device and method may vary. It is also to be understood that the terminology used herein is for purpose of describing particular embodiments only, and is not intended to be limiting. It must be noted that, as used in the specification and the appended claim, the articles "a," "an," "the," and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings does not exclude other elements or steps.

### Brief description of drawings

The above and other aspects of the present invention will now be described in more detail, with reference to appended drawings showing embodiments of the invention. The figures should not be considered limiting the invention to the specific embodiment; instead they are used for explaining and understanding the invention.

As illustrated in the figures, the sizes of layers and regions are exaggerated for illustrative purposes and, thus, are provided to illustrate the general structures of embodiments of the present invention. Like reference numerals refer to like elements throughout.
Figure 1 is a schematic front view illustration of a template for producing a light out-coupling portion on a surface of a light guide.
Figure 2 is a schematic side view illustration of the same template as in figure 1.
Figure 3 illustrates a method for producing a light out-coupling portion on a surface of a light guide.
Figures 4a - 4c illustrate the use of the method for forming of an out-coupling portion on an inner surface of a light guide in the form of a container wall.
Figure 5 is a schematic side view illustration of another template for producing a light out-coupling portion on a surface of a light guide.

### Detailed description

The present invention will now be described more fully hereinafter with reference to the accompanying drawings, in which preferred embodiments of the invention are shown. This invention may, however, be embodied in many different forms and should not be construed as limited to the embodiments set forth herein; rather, these embodiments are provided for thoroughness and completeness, and fully convey the scope of the invention to the skilled person. Further features of, and advantages with, the present invention will become apparent when studying the appended claims and the following description. The skilled person will realise that different features of the present invention may be combined to create embodiments other than those described in the following, without departing from the scope of the present invention. Features of one aspect may be relevant to anyone of the other aspects; references to these features are hereby made.

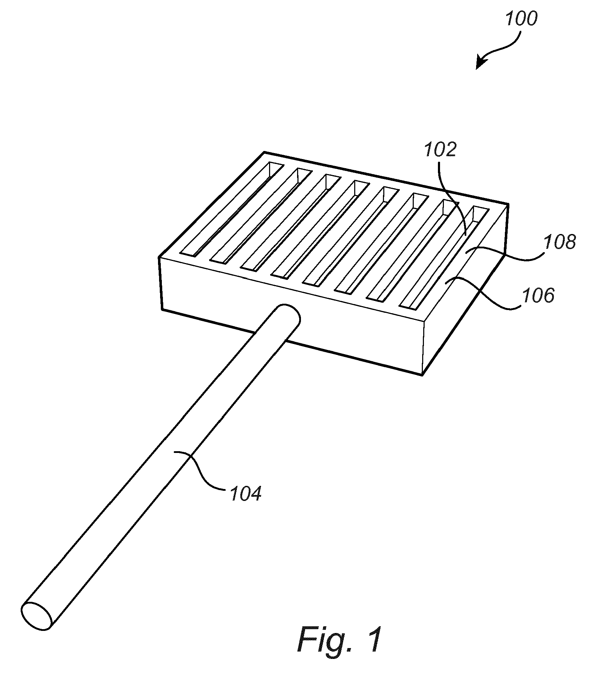

Figure 1 illustrates a front view of a template 100 comprising a pattern 102 representing a structure of a light out-coupling portion to be formed on a surface of the light guide. The template 100 is arranged on a holder 104 for positioning of the template 100. The holder 104 has in this embodiment an elongated shape but may in other embodiments be formed differently. The holder 104 may for example be a surface onto which the template is arranged.

The holder 104 may further be arranged in a positioning system (not shown) arranged to position the template 100 at a predetermined location on the surface of the light guide.

The template 100 comprises a substrate 106 having a surface structure 108. The surface structure 108 comprises recesses and protrusions. The substrate 106 may be of silicon. The recesses and protrusions of the surface structure 108 may be formed by depositing metal on the substrate 106. Hence, at least a portion of the substrate 106 thereby comprises a metalized surface structure 108 forming the pattern 102. The metal may for example comprise aluminium or copper. The substrate 106 may alternatively comprise a silicon nitride substrate or other suitable materials.

The surface structure of the substrate 106 may for example be formed by optical lithography, electron beam lithography or nano-imprint lithography. A pattern 102 may thereby be formed with high resolution and high repeatability. The deposition of the metal surface may be provided by sputtering and/or evaporation of a metal. Techniques for forming the surface structure and for depositing the metal on the the surface structure are known to the skilled person in the art and will for brevity not be discussed further.

The pattern 102 may comprise nanometer scale features. The pattern 102 is exemplified to be a grating structure arranged to efficiently diffract light of a given wavelength, as will be described in more detail below. In other embodiments the pattern may for example comprise a lens structure, a corrugated surface or a pattern in the shape of a symbol or a text.

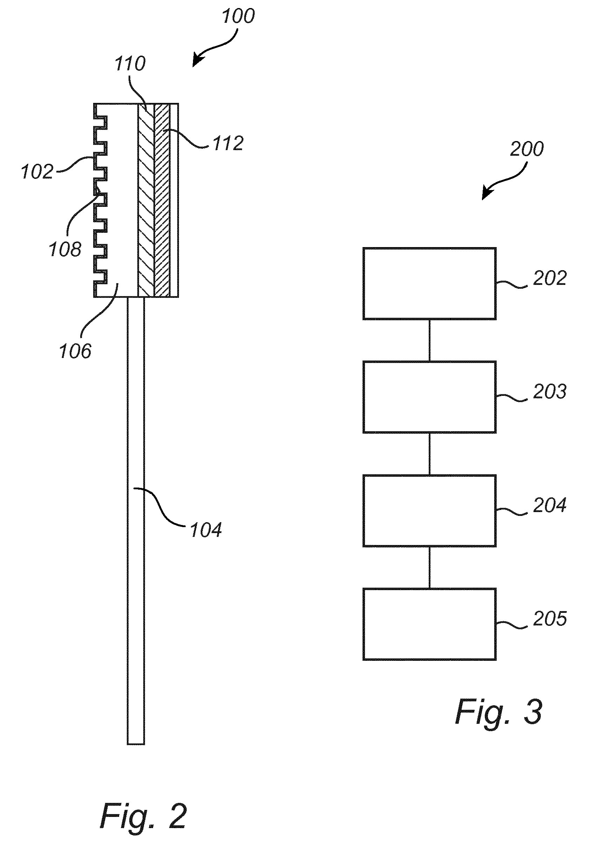

The template 100 further comprises a heating element 110 arranged in contact with the substrate 106 within the template 100 as illustrated in the side view of the template 100 in figure 2. The heating element 110 may be a resistive heating element. The heating element may for example comprise a coiled resistive wire arranged inside a ceramic material. When an electrical current is applied to the wire, it generates heat that is transferred to the ceramic material and then to the silicon substrate and the metalized top surface. Alternatively, an etched foil heater comprising a resistive foil with a pattern etched through may be used. The foil heater may comprise a patterned current path such as a maze-like pattern. This resistive foil may be sandwiched between two sheets of adhesive and a dielectric material, such as polyimide or mica.

The heating element may be arranged for inductive heating.

The template 100 may comprise a cooler 112 arranged to cool the surface of the light guide. By cooling the surface of the light guide after heating, rapid solidification of the applied pattern 102 may be achieved. Hence, the pattern 102 may efficiently be transferred to a surface of a light guide forming the light out-coupling portion. The cooler may for example comprise a Peltier element.

Figure 3 illustrates a method 200 for producing a light out-coupling portion on a surface of a light guide. The method 200 comprising the acts of: applying 202 a template comprising a pattern representing a structure of the light out-coupling portion at the container wall surface, heating 204 the template to a given temperature whereby a portion of the surface of the light guide is locally melted and solidified such that the pattern is transferred to the surface of the light guide forming the light out-coupling portion.

The method may further comprise the act of pressing 203 the template to the surface of the light guide and/or cooling 205 the template. The act of pressing 203 may be performed before or while the act of heating 204 and/or the act of cooling 205 is performed.

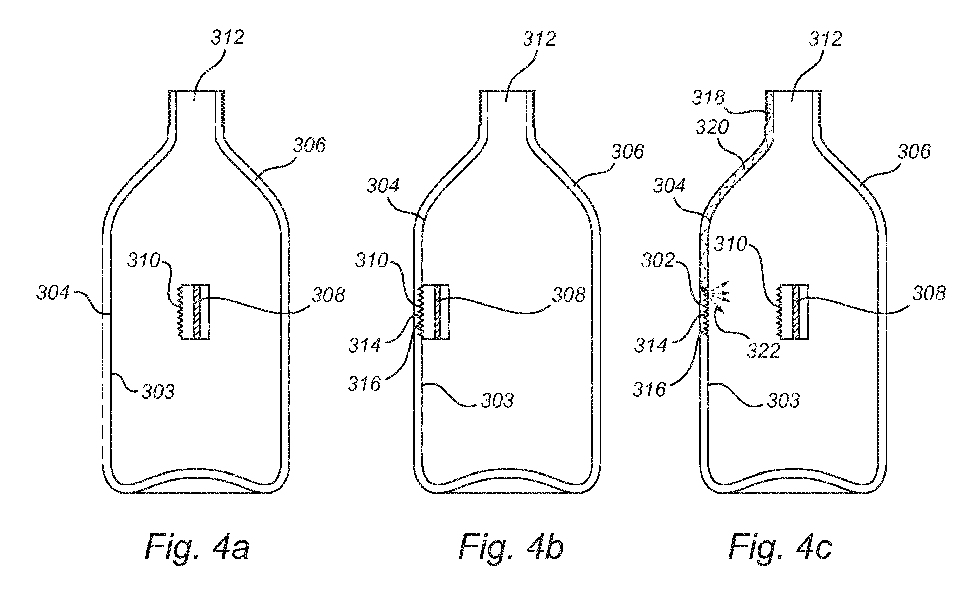

Figures 4a - 4c illustrate the use of the method 200 for forming of an out-coupling portion 302 on a container wall surface 304 of a container 306. Hence, the light guide is in the following described as being formed by the container wall 314 of the container 306. The container wall 314 thereby guides light inside the material forming the container wall 314, as will be discussed below.

It should, however, be realized that the light guide may in other embodiments have different forms and may comprise different materials than described in relation to figures 4a - 4c. The light guide may, for instance, be a light concentrator or an optical fibre. Hence, it is realized that the method 200 may be applied to surfaces of light guides of different kinds than the one formed by the container wall 314.

To this end, it shall be noted that the method 200 may also be used for forming an out-coupling portion 302 on an outer container wall surface of a container such as the bottom or the neck of the container.

In Figs. 4a - 4c, the container 306 is illustrated as a bottle but may in other embodiments be formed differently. The container may for example be a perfume bottle or a jar for food stuff. According to one embodiment the container is a bottle for containing a liquid such as a beverage. The beverage may e.g. be vodka, wine, port wine, beer or other beverages containing alcohol.

In figure 4a a template 308 is shown to be inserted into the container 306. The template 308 comprises a pattern 310 representing a structure of the light out-coupling portion 302. The template 308 may further be arranged on a holder (not shown) which allows for simple positioning of the template 308 within the container 306.

The template 308 may have a width of 8 mm, and a thickness of 2 mm allowing the template 308 to, for example, be inserted into the container 306. The small size of the template 308 thereby allows for insertion of the template 308 into the opening 312 of the container 306.

The template 308 may in other embodiments have a width in the range of 5 mm - 40 mm, and a thickness of in the range of 0.5 mm - 3 mm.

The template 308 may further have a length in the range of 5 mm - 100 mm.

In figure 4b the template 308 is applied 202 at the inner surface 303 of the container 306. In other words, the template 308 is arranged in contact with the container wall surface 304 of the container wall 314. In some embodiments the template 308 may be pressed 203 against the container wall surface 304. The template 308 is moreover heated 204 to a given temperature which induces a portion 316 of the container wall surface 304 to locally melt such that the pattern 310 is transferred to the container wall surface 304, as illustrated in figure 4c. Hence, the light out-coupling portion 302 is formed by the method 200.

The template 308 may thereafter be removed from the container wall surface 304. The template 308 may further be applied to another location on the container 306 or be removed from the container 306.

The act of pressing 203 the template 308 to the container wall surface 304 is advantageous as the material of the container wall 314 may be redistributed by the forces resulting from the pressing 203 the template 308 into container wall surface 304. Heat is, moreover, more efficiently transferred from the template 308 to the container wall surface 304 by the act of pressing 203.

The method 200 may further comprise the act of cooling 205 the template 308. The cooling 205 of the template 308 further improves the solidification of the locally melted portion 316. Hence, the pattern may be efficiently transferred to the container wall surface 304. In other words, the cooling mitigates re-flow of material of the container wall 314 after the template 308 is removed from the container wall surface 304.

The act of pressing 203 may further be performed while the act of heating 204 and/or the act of cooling 205 is performed. A more efficient transfer of the pattern may thereby be obtained.

The container 306 may comprise a glass material. In other embodiments the container 306 may comprise other materials, for example, a plastic material.

The material of the container wall 314, i.e. the light guide, may be translucent or transparent. The wording *"translucent"* is to be understood as permitting the passage of light. The container 306 may therefore comprise a portion that is clear, in other words transparent to light, and/or a portion that is transmitting and diffusing light such that objects within the container 306 cannot be seen clearly from outside the container. Hence, the translucent material may either be clear, i.e. transparent, or transmitting and diffusing light so that objects beyond cannot be seen clearly. *"Transparent"* is to be understood as *"able to be seen through".*

As discussed above, the container wall 314 may act as the light guide as illustrated in figure 4c by the light path 318. A light source, not shown, may further be arranged to emit light 320 into the container wall 314 of the container 306 such that the light 320 may propagate within the container wall 314. The propagation of light within the container wall 314 may be by total internal reflection, TIR. Light distributed by TIR may efficiently propagate within the container wall 314. Hence, a larger portion of light 320 may efficiently be transported within the container wall 314.

TIR should be construed as an optical effect that occur when a ray of light reaches a boundary between a first and a second medium at an angle larger than a critical angle, with respect to the normal of the boundary surface. For TIR to occur it is needed that the refractive index of the first medium is larger than the refractive index of the second material, i.e. in order for the light ray to be totally reflected at the boundary such that no light propagate beyond the boundary and all light is substantially reflected at the boundary.

A smooth surface structure of the material of the container wall 314 may further improve the efficiently at which light 320 propagates within the container wall 314. In other words, a substantial portion of the light sent into the container wall 314 may propagate within the container wall 314 and be guided to the light out-coupling portion 302 without being scattered or refracted out from the container wall 314.

The light out-coupling portion 302 is, however, arranged to couple out light 320 from the container wall 314 and into the interior of the container 306. The light out-coupling portion 302 may refract, diffract, reflect and/or scatter light such that at least a portion of the light 322 is redirected in space.

The light out-coupling portion 302 is illustrated as a diffraction grating. The wording *"diffraction grating"* should be understood as an optical element having a periodic structure which may diffract a beam of light in a predetermined direction. The directions of these beams depend on the spacing of the grating and the wavelength of the light so that the grating acts as the dispersive element. Hence, if the light 320 within the container wall 314 is white, the portion of the light 322 may comprise a plurality of colours that are separated in space such that a rainbow like light distribution may be formed within the container 306.

Efficient redirection of light of different colours reflected from and/or transmitted through the diffraction grating may thereby be obtained.

The diffraction grating may be referred to as a transmission grating as light 320 from within the container wall surface 304 is coupled out and diffracted in different directions.

The light out-coupling portion 302 may alternatively comprise a corrugated surface structure arranged to scatter light. The corrugated surface structure may further comprise patterns of for example half-sphere structures or pyramids providing efficient redistribution of light.

It should be noted that the light out-coupling portion may be arranged to couple out light from within the container walls in different ways, giving rise to various kinds of optical effects that may be observed in e.g. a liquid inside the container or in the air outside the container.

The light out-coupling portion may for example be arranged to produce a hologram within the contents of the container. The light out-coupling portion may further be arranged to redirect light such that an image is projected in a liquid inside the container. The image may be formed by redirecting the light sent into the container wall via the light out-coupling portion into the liquid inside the container.

The light out-coupling portion may be a Fresnel lens. A thinner lens structure in the light out-coupling portion may thereby be provided.

It should be noted that the light out-coupling portion may alternatively be formed on an outer surface of the container. Hence, light may be coupled out from the container wall and into the exterior of the container.

The template may comprise nanostructure features which may be transferred to the container wall surface. A surface structure with a larger surface may thereby be provided increasing the amount of light that may be coupled out of the container wall.

In the case of the material of the container wall surface 304 comprises glass, the given temperature may be in the range of 500°C - 900 °C. Temperatures in this range facilities an effective local melting of the container wall surface 304. The act of heating 204 the template 308 may, further, for example be provided for a time period in the range of 1 - 10 microseconds. An efficient transfer of a pattern 310 from the template 308 to the container wall surface 304 may thereby be achieved.

The act of pressing 203 and the act of cooling 205 may further be performed in a time period in the range of 1 - 10 milliseconds. The time period reduces the amount of material of the container wall surface 304 that is heated which improves the resolution of the pattern 310 that is formed in the container wall surface 304 of the container 306.

It should, however, be noted that the temperatures and time periods may differ for other embodiments. A method for producing a light out-coupling portion on a surface of a light guide where the light guide comprises a plastic material may for example be different. The given temperature may for example be reduced if the melting point of the material of the surface of the light guide is lower than for glass. The person skilled in the art further realizes that the present invention by no means is limited to the preferred embodiments described above. On the contrary, many modifications and variations are possible within the scope of the appended claims.

For example, the method may further comprise the act of metalizing at least a sub-portion of the light out-coupling portion.

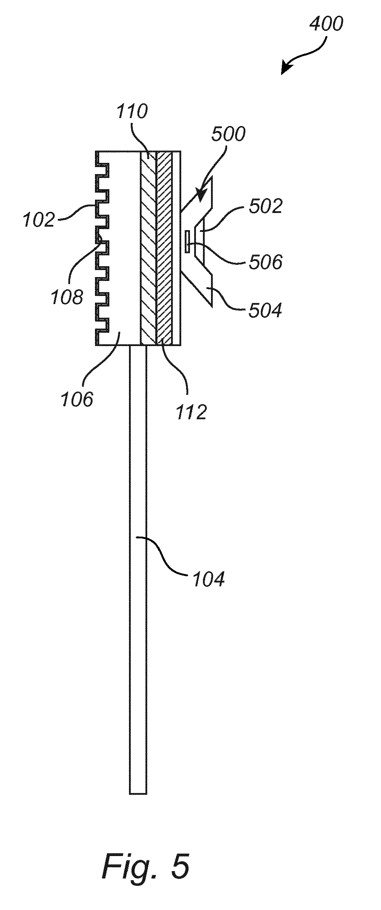

A template 400 allowing for depositing a metal on at least a sub-portion of a light out-coupling portion is illustrated in figure 5. The template 400 comprises an evaporator 500 arranged to evaporate metal onto a surface brought in the vicinity of the evaporator 500. The wording *"vicinity of"* may be understood as the surface being at a distance in the range of 0.1 mm to 10 mm to the evaporator 500. A metal structure or metal layer may thereby be formed on the light out-coupling portion.

It should be noted that the pattern 102 and the evaporator 500 are in figure 5 arranged on opposing sides of the template 400. The same template 400 may, however, allow for efficient formation of a light out-coupling portion on a container wall surface, and, after rotation along the long axis of the template 400, for metallization of at least a sub-portion of the light out-coupling portion. According to other embodiments the pattern 102 and the evaporator may be arranged differently in respect to each other, for example, on the same side surface of the template.

The evaporator 500 further comprises a metal source 502, a crucible 504, and an additional heater 506. The metal source 502 is arranged in the crucible 504. The crucible 504 is in thermal contact with the additional heater 506 allowing for selective heating of the metal source 502. The additional heater 506 may for example be a heating filament arranged to heat the crucible 504 when a current is passed through the heating filament. The metal source 502 may for example comprise Au or Ag.

The crucible 504 may further be in thermal contact with the cooler 112 mitigating damage to the crucible 504 during evaporation of the metal source 502.

According to other embodiments the crucible 504 may be heated by the heater 110.

The above mentioned features of the templates 100, 308, when applicable, apply to the template 400 as well. In order to avoid undue repetition, reference is made to the above.

The metalized light out-coupling portion may form a plasmonic structure. The plasmonic structure may support a surface plasmon resonance, SPR, which may be used as colour indicator and/or sensor, to measure changes in the refractive index occurring at or in the vicinity of the surface of the plasmonic structure supporting the surface plasmon.

The wording *"plasmonic structure"* should be construed as a structure in which plasmons may be excited. Plasmons should here be understood as quanta of plasma oscillations associated with a collective oscillation of charge density. The charges may for instance be provided by electrons.

The wording *"surface plasmon resonance",* SPR, is to be understood as a resonant oscillation of charges at the interface between a negative and positive permittivity material which is excited by for instance light. The resonance condition may be achieved when the frequency of incident photons matches the natural frequency of charges, e.g. electrons, oscillate against the restoring force of for instance a positive nuclei.

To this end, when light comprising a p-polarized component is incident on the plasmonic structure is interface in such a way that the propagation constant and energy of resultant evanescent wave is equal to that of an allowed surface plasmon wave at the interface, a strong absorption of light takes place as a result of transfer of energy and light sent out from the plasmonic structure may have an optical spectrum showing a sharp dip or peak at a particular wavelength known as the resonance wavelength. In other words, the generated propagating surface plasmon wave may affect the spectral composition and/or intensity of the light from within the container wall. The intensity and spectral composition of the light coupled out from the light out-coupling portion may, moreover, change as a result of a change in the refractive index at or in the vicinity of the plasmonic structure. The colour of the colour indicator may therefore change.

The plasmonic structure may be arranged on an inner surface of a container. The colour of the light coupled out via the plasmonic structure may then change if, for example the content of the container is changed or if a material such as a contaminant is bound to the plasmonic structure. Hence, the plasmonic structure may used for optical detection of a compound such as a bacteria or a molecule, being present at or in the vicinity of the light out-coupling portion. The plasmonic structure may be employed for authenticity control of for example a liquid or a solid within the container.

The SPR may from the above be understood to be sensitive to changes in the material properties of surrounding the plasmonic structure. For example, a change in the dielectric constant affects the wavelength at which the SPR occurs; making SPR based structures efficient sensors. In SPR sensors with spectral interrogation, the resonance wavelength λ₀ is determined as a function of the refractive index of the environment, n₀, of the plasmonic structure. If the refractive index of the environment surrounding the plasmonic structure is altered to n₁ the resonance wavelength may shift in wavelength to λ₁. The change in the optical spectrum caused by a change in refractive index may alternatively be obtained by determining the peak intensity and/or the full width at half maximum of optical spectra.

The detection of a change in the refractive index may be by a visual inspection by a person examining the plasmonic structure or by acquiring data from a detector such as a spectral resolving detector or a camera sensitive to light.

A plasmonic structure providing a localized surface plasmon resonance, LSPR, may be achieved by providing metal nanostructures on the light out-coupling portion. The wording *"localized surface plasmon resonance"* is to be understood as an excited state of the charge carriers within the plasmonic structure, which can be excited by photons or, equivalently, by the electromagnetic field of light incident on the plasmonic structure. The LSPR condition is a resonance condition associated to the collective oscillation of charge density and to the boundary conditions resulting from the finite size of the plasmonic structure.

The LSPR spectral position depends on the composition, size or shape and the arrangement of the nanostructures, as well as the refractive index of the refractive index of the materials surrounding the nanostructures. The spectral composition of the light from the plasmonic structure may depend on how the pattern of the light out-coupling portion is structured, i.e. a structural colour may be obtained.

According to another embodiment, the light out-coupling portion may comprise a surface-enhanced Raman scattering, SERS, structure. The wording *"surface-enhanced Raman scattering"* structure should be understood as a structure that enhances Raman scattering by compounds such as molecules or bacteria adsorbed on the surface of the structure. The enhanced Raman scattering may be used to identify a compound binding to the SERS structure. Hence, the presence of a compound at or on the light out-coupling portion may be detected. In other words, the spectral response of light coupled out from the light out-coupling portion comprising the SERS structure to which a compound has been bound may be different compared to light coupled out from the light out-coupling portion without a bound compound.

The SERS structure is further arranged to provide local field enhancement when illuminated by light. In other words, the SERS structure provides concentration of electrical fields at or in the vicinity of the surface of the SERS structure. The enhanced electrical fields may increase the excitation efficiency of a compound binding to the surface of the SERS structure. The amount of scattered radiation from adsorbed compounds on the SERS structure may thereby be enhanced. As a result, an increased Raman scattering signal may be detected for the absorbed compound. Hence, the SERS structure may used for optical sensing of a compound such as a bacteria or a molecule, being present at or in the vicinity of the light out-coupling portion. The SERS structure may be employed for authenticity control of for example a liquid or a solid within a container.

It should further be understood that the LSPR occurs when the electromagnetic radiation interacts with the plasmonic structure. As a result an enhanced local electromagnetic field is created in the close vicinity of the plasmonic structure. The LSPR is further responsible for the electromagnetic-field enhancement that leads to SERS. The strength of the enhancement and the spatial extent of the enhanced field depend on a number of parameters such as the material, size, shape, and environment of the plasmonic structure. The enhanced electric field is beneficial as it improves the sensitivity of the plasmonic structure. Hence, the SERS substrate provides improved detection efficiency of a compound binding to it.

The metal of the metal plasmonic structure may for example be selected from a group consisting of Au, Ag, Cu, Al, Mg, Ni, Pd and Pt, or alloys comprising at least one metal selected from the group. These materials may provide efficient formation and/or propagation of surface plasmons.

Additionally, variations to the disclosed embodiments can be understood and effected by the skilled person in practicing the claimed invention, from a study of the drawings, the disclosure, and the appended claims.

## Claims

1. A method for producing a light out-coupling portion on a surface of a light guide (304), the method (200) comprising the acts of:
applying (202) a template (100, 308, 400) comprising a pattern (102, 310) representing a structure of the light out-coupling portion (302) at the surface of the light guide (304),
heating (204) the template (100, 308, 400) to a given temperature
whereby a portion (316) of the surface of the light guide (304) is locally melted and solidified such that the pattern (102, 310) is transferred to the surface of the light guide (304) forming the light out-coupling portion (302).

2. The method according to claim 1, wherein the act of applying (202) further comprises applying the template (308) on an inner surface (303) of the light guide (304).

3. The method according to claim 1 or 2, wherein the method further comprises the act of pressing (203) the template (100, 308, 400) to the surface of the light guide (304).

4. The method according to any one of the claims 1 - 3, wherein the method further comprises the act of cooling (205) the template (100, 308, 400).

5. The method according to claims 3 and 4, wherein the act of pressing (203) is performed while the act of heating (204) and/or the act of cooling (205) is performed.

6. The method according to claims 3 - 5, wherein the act of heating (100, 308), the act of pressing (203) and the act of cooling (205) are performed in a time period in the range of 1 - 10 milliseconds.

7. The method according to any one of the claims 1 - 6, wherein the light guide (304) comprises a glass material.

8. The method according to any one of the claims 1 - 9, wherein the light out-coupling portion (302) comprises a lens structure, a grating structure, and/or a corrugated surface.

9. A template for producing a light out-coupling portion on a surface of a light guide, the template (100, 308, 400) comprising:
a substrate (102, 310) representing a structure of the light out-coupling portion (302) at the surface of the light guide (304), and
a heating element arranged to heat the substrate (106) whereby a portion (316) of the surface of the light guide (304) is locally melted and solidified such that the pattern (102, 310) is transferred to the surface of the light guide (304) forming the light out-coupling portion (302).

10. The template according to claim 9, further comprising a cooler (112) arranged to cool the surface of the light guide (304) such that it is solidified and the pattern (102, 310) may efficiently be transferred to the surface of the light guide (304) forming the light out-coupling portion (302).

11. The template according to claim 9 or 10, wherein the template (100, 308, 400) has a width in the range of 5 mm - 40 mm, and a thickness of in the range of 0.5 mm - 3 mm.

12. The template according to any one of the claims 9 - 11, wherein the template (100, 308, 400) has a length in the range of 5 mm - 100 mm.

13. The template according to any one of the claims 9 - 12, wherein the template (100, 308, 400) comprises a substrate (106) having a metalized surface structure (108), the metalized surface structure comprising the pattern (102, 310).

14. The template according to any one of the claims 9 - 13, wherein the pattern (102, 310) comprises nanometer scale features.

15. A light guide comprising a light out-coupling portion produced according to any one of the claims 1 - 8.
